# EUROPÄISCHE PATENTSCHRIFT

(11) **EP 2 285 625 B1**
(45) Veröffentlichungstag und Bekanntmachung des Hinweises auf die Patenterteilung: **17.07.2013**
(21) Anmeldenummer: 09745686.7
(22) Anmeldetag: 07.05.2009
(51) Int. Cl.: B60R 11/02

(54) **ANZEIGEEINRICHTUNG**
DISPLAY DEVICE
SYSTÈME D'AFFICHAGE

(30) Priorität: 14.05.2008 DE 102008023469
(43) Veröffentlichungstag der Anmeldung: 23.02.2011
(73) Patentinhaber: Continental Automotive GmbH, 30165 Hannover (DE)
(72) Erfinder: KISSEL, Robert Wolfgang, 63329 Egelsbach (DE); KARL, Klaus, 63571 Gelnhausen (DE); NEHM, Georg, 63843 Niedernberg (DE)
(86) Internationale Anmeldenummer: PCT/EP2009/055527
(87) Internationale Veröffentlichungsnummer: WO 2009/138353

(56) Entgegenhaltungen:
- WO-A-2007/137998
- DE-A1- 10 008 887
- DE-A1-102005 052 031
- JP-A- 11 007 263

## Beschreibung

Die Erfindung bezieht sich auf eine Anzeigeeinrichtung zur Anzeige von Informationen, insbesondere für ein Fahrzeug, mit einem eine Gehäuseöffnung aufweisenden Gehäuse und mit einer ein Display aufweisenden Anzeigeeinheit, die zwischen einer Ruheposition, in der die Anzeigeeinheit vollständig in das Gehäuse eingefahren ist, und einer Anzeigeposition, in der die Anzeigeeinheit aus dem Gehäuse in eine zumindest annähernd senkrechte Lage seines Displays ausgefahren ist, bewegbar antreibbar ist, mit einer Abdeckung, die zwischen einer die Gehäuseöffnung abdeckenden Abdeckposition und einer die Gehäuseöffnung freigebenden Freigabeposition bewegbar antreibbar ist, mit von einem Drehantrieb antreibbaren Kopplungsmitteln, mittels derer die Anzeigeeinheit und die Abdeckung bewegbar antreibbar sind und mit denen die Bewegungen der Anzeigeeinheit und der Abdeckung koppelbar sind.

Bei einer bekannten, insbesondere in die Instrumententafel eines Kraftfahrzeugs eingesetzten Anzeigeeinrichtung weisen die Kupplungsmittel eine Vielzahl an Schwenkhebeln und Schwingen auf und sind somit sehr bauteilaufwendig aufgebaut, was auch einen erheblichen Montageaufwand und Bauraum erfordert. Die DE 100 08 887 A1 beschreibt eine Anzeigeeinrichtung gemäß den Oberbegriff des Anspruchs 1.

Durch die Kopplungsmittel werden von der Anzeigeeinheit und der Abdeckung kombinierte rotatorische und translatorische Bewegungen ausgeführt, um aus der Ruheposition bzw. der Abdeckposition in die Anzeigeposition bzw. die Freigabeposition zu gelangen.

Aufgabe der Erfindung ist es eine Anzeigeeinrichtung der eingangs genannten Art zu schaffen, die aus wenigen, einfachen Bauteilen besteht.

Diese Aufgabe wird erfindungsgemäß dadurch gelöst, dass die Kopplungsmittel eine um eine ortsfeste erste Drehachse drehbare erste Koppel aufweisen deren freies Ende mittels einer ersten Anlenkung an der Abdeckung angelenkt ist, wobei die Anzeigeeinheit in einem Abstand zur ersten Anlenkung der ersten Koppel mittels einer zweiten Anlenkung an der Abdeckung sowie in Abständen zur ersten Anlenkung und zur zweiten Anlenkung mittels einer dritten Anlenkung an dem freien Ende einer zweiten Koppel angelenkt ist, die mit ihrem anderen Ende um eine zur ersten Drehachse ortsfeste zweite Drehachse schwenkbar ist.

Durch diese Ausbildung sind sowohl die Anzeigeeinheit als auch die Abdeckung Komponenten der gemeinsamen Kupplungsmittel, wodurch nur wenige einfach aufgebaute Teile zum integrierten Bewegungsantrieb von Anzeigeinheit und Abdeckung mittels eines einzigen Drehantriebs benötigt werden.

Insbesondere, wenn dabei miteinander verbundene Kopplungsmittel zweifach parallel in einem Abstand voneinander vorhanden sind, werden Anzeigeeinheit und Abdeckung von den Kopplungsmitteln nicht nur bewegbar angetrieben sondern auch getragen, so dass keine Halterungen sowie Führungen von Anzeigeeinheit und Abdeckung an dem Gehäuse erforderlich sind.

Dies ermöglicht es, die Kopplungsmittel auf der der Gehäuseöffnung abgewandten Seite der Anzeigeeinheit anzuordnen, wodurch ein Einblick von der Beobachterseite her in das Gehäuse und auf die Kopplungsmittel verhindert wird.

Da die Kopplungsmittel sich nicht in den Seitenbereichen von Anzeigeeinheit und Abdeckung befinden müssen, sind geringe Spalten neben der Anzeigeeinheit möglich.

Das Bauraumerfordernis ist weiterhin dadurch sehr gering, dass sich die Anzeigeeinheit in der Ruheposition in einer annähernd horizontalen Lage befindet, aus der sie mit einer rotatorischen und translatorischen Bewegung in die Anzeigeposition bewegbar ist, wobei gleichzeitig auch die Abdeckung mit einer rotatorischen und translatorischen Bewegung aus der Abdeckposition in die Freigabeposition bewegt wird.

Alle Drehachsen und Anlenkungen sind parallel zueinander ausgerichtet.

Mittels einer vierten Anlenkung kann an der Abdeckung zwischen der ersten Anlenkung und der zweiten Anlenkung eine Koppel mit ihrem einen Ende angelenkt sein, deren anderes Ende um eine ortsfeste dritte Drehachse frei drehbar ist und mit der ersten Koppel, der Abdeckung und der dritten Koppel ein Viergelenk bildet, wodurch der Bewegungsablauf eindeutig definiert ist.

Je nach dem vorhandenen Bauraum kann eine der Koppeln der Kopplungsmittel von dem Drehantrieb drehbar antreibbar sein.

Es ist aber auch möglich, dass an der ersten Koppel koaxial zur ersten Drehachse ein erstes Getrieberad und an der zweiten Koppel koaxial zur zweiten Drehachse ein zweites Getrieberad drehfest angeordnet ist und die Drehbewegung des ersten Getrieberads über ein drehbar gelagertes Zwischenrad auf das zweite Getrieberad übertragbar ist, wobei in einfacher Weise die Getrieberäder und das Zwischenrad ein Stirnradgetriebe bilden.

Durch diese Getriebekopplung erfolgt ebenfalls eine Zwangskopplung mit einer Einschränkung der Freiheitsgrade, wodurch der Bewegungsablauf eindeutig definiert ist.

Zur Abdeckung durch die Anzeigeeinheit gegenüber einem Beobachter können die erste, die zweite und dritte Koppel oder die erste und zweite Koppel sowie die Getrieberäder und das Zwischenrad in dem Gehäuse auf der der Gehäuseöffnung abgewandten Seite der Anzeigeeinheit angeordnet sein.

Es ist möglich, dass der Drehantrieb ein elektromotorischer Drehantrieb ist, der sowohl in Öffnungs- und Schließrichtung oder aber nur in Öffnungsrichtung drehbar antreibbar ist. Im zweiten Fall könnte die Schließbewegung durch manuelle Beaufschlagung der Abdeckung erfolgen.

Wesentlich kostengünstiger ist es aber, wenn der Drehantrieb ein Federantrieb, insbesondere ein Torsionsfederantrieb ist, durch den die erste Drehachse in Öffnungsantriebsrichtung der Abdeckung federbeaufschlagt ist.

Das Schließen erfolgt manuell durch eine Zugbeaufschlagung der Abdeckung, wodurch sich auch die Anzeigeeinheit durch die Koppelung der Bewegungen selbsttätig in die Ruheposition bewegt. Gleichzeitig wird dabei der Federantrieb gespannt.

Zum Halten der Abdeckung in der Abdeckposition ist dabei eine der Komponenten der Kopplungsmittel mittels einer manuell entarretierbaren Riegelvorrichtung in der Ruheposition der Anzeigeeinheit oder der Abdeckposition der Abdeckung arretierbar, wobei zum Öffnen der Abdeckung und Ausfahren der Anzeigeeinheit die Riegelvorrichtung mittels eines am Gehäuse oder an der Abdeckung angeordneten Tasters entriegelbar sein kann.

Die Anzeigeeinheit wird in der Anzeigeposition stabil und erschüttungsunempfindlich gehalten, wenn die Anzeigeposition der Anzeigeeinheit durch einen Anschlag definiert ist, an dem die Anzeigeeinheit in der Anzeigeposition in Anlage ist und der die Ausfahrbewegung der Anzeigeeinheit begrenzt.

Dazu kann in einfacher Ausbildung die Anzeigeeinheit einen sich quer zur Ausfahrbewegung der Anzeigeeinheit erstreckenden Anschlagzapfen aufweisen, der mit der Ausfahrbewegung der Anzeigeeinheit in einer Längsnut bewegbar ist, deren eines Ende den Anschlag bildet, an dem in der Anzeigeposition der Anschlagzapfen in Anlage ist.

Ausführungsbeispiele der Erfindung sind in der Zeichnung dargestellt und werden im Folgenden näher beschrieben. Es zeigen:
- Figur 1: eine Seitenansicht mit geöffnetem Gehäuse eines ersten Ausführungsbeispiels einer Anzeigeeinrichtung mit einer Abdeckung in Abdeckposition,
- Figur 2: eine Seitenansicht der Anzeigeeinrichtung nach Figur 1 mit der Abdeckung in halboffener Position,
- Figur 3: eine Seitenansicht der Anzeigeeinrichtung nach Figur 1 mit der Abdeckung in Freigabeposition,
- Figur 4: eine perspektivische Rückansicht eines zweiten Ausführungsbeispiels einer Anzeigeeinrichtung mit einer Abdeckung in Abdeckposition,
- Figur 5: eine perspektivische Rückansicht der Anzeigeeinrichtung nach Figur 4 mit der Abdeckung in halboffener Position,
- Figur 6: eine perspektivische Rückansicht der Anzeigeeinrichtung nach Figur 4 mit der Abdeckung in Freigabeposition,
- Figur 7: eine Seitenansicht von Abdeckung, Anzeigeeinheit und Kopplungsmitteln der Anzeigeeinrichtung nach Figur 4 mit der Abdeckung in Abdeckposition,
- Figur 8: eine Seitenansicht von Abdeckung, Anzeigeeinheit und Kopplungsmitteln der Anzeigeeinrichtung nach Figur 4 mit der Abdeckung in halboffener Position,
- Figur 9: eine Seitenansicht von Abdeckung, Anzeigeeinheit und Kopplungsmitteln der Anzeigeeinrichtung nach Figur 4 mit der Abdeckung in Freigabeposition,
Figur 10 eine Seitenansicht der Anzeigeeinrichtung nach Figur 4 mit der Abdeckung in Abdeckposition,
Figur 11 eine Seitenansicht der Anzeigeeinrichtung nach Figur 4 mit der Abdeckung in halboffener Position,
Figur 12 eine Seitenansicht der Anzeigeeinrichtung nach Figur 4 mit der Abdeckung in Freigabeposition,
Figur 13 eine perspektivische Explosionsdarstellung der Anzeigerichtung nach Figur 4.

Die in den Figuren dargestellten Anzeigeinheiten weisen ein Gehäuse 5 mit einer Gehäuseöffnung rechteckigen Querschnitts auf, die durch eine entsprechende flächige Abdeckung 4 verschließbar ist.

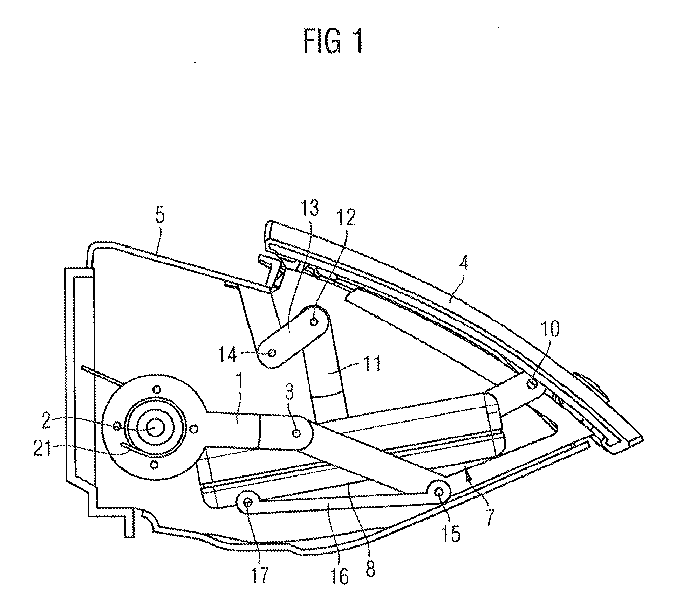

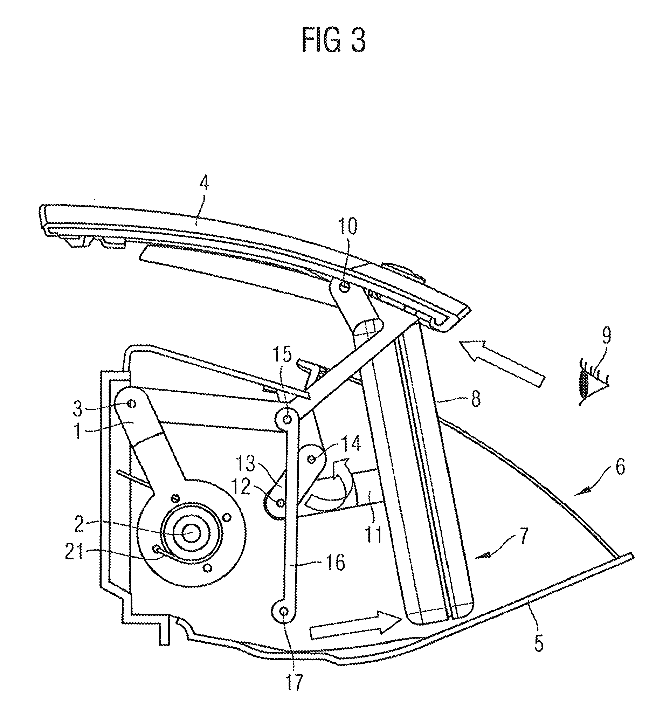

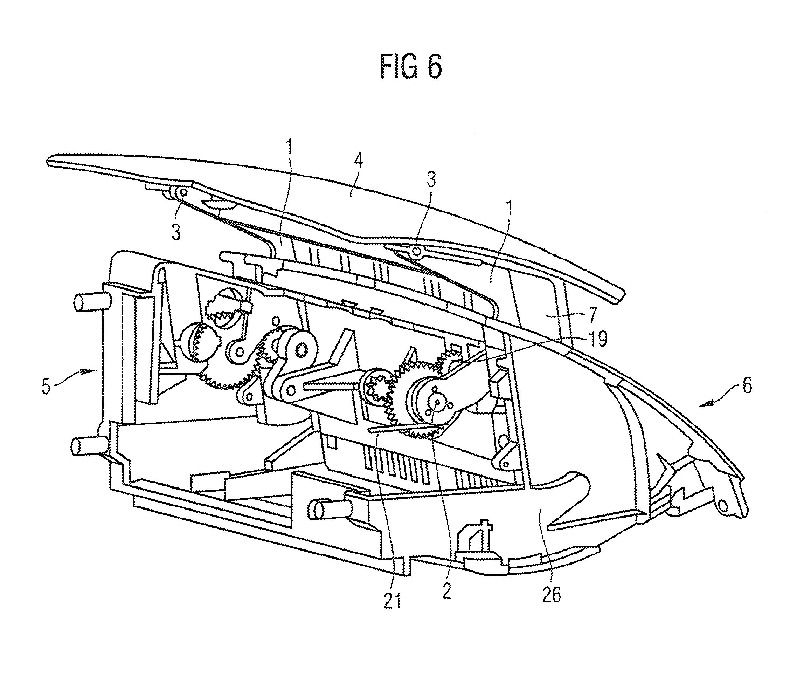

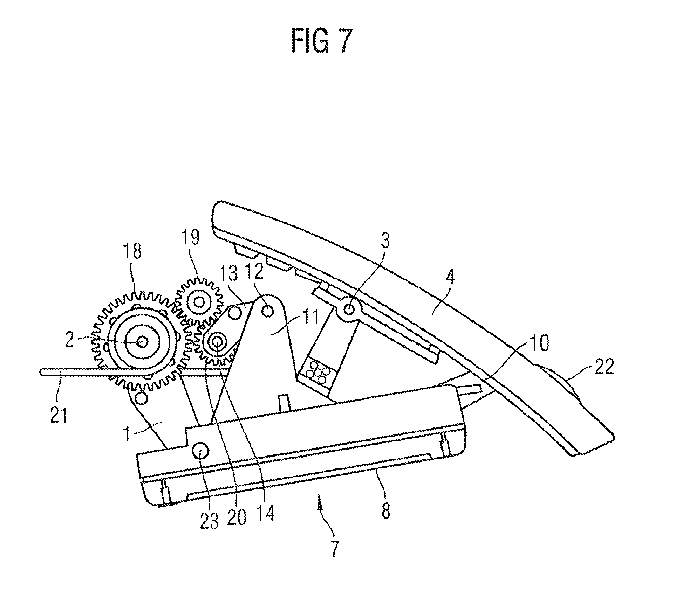

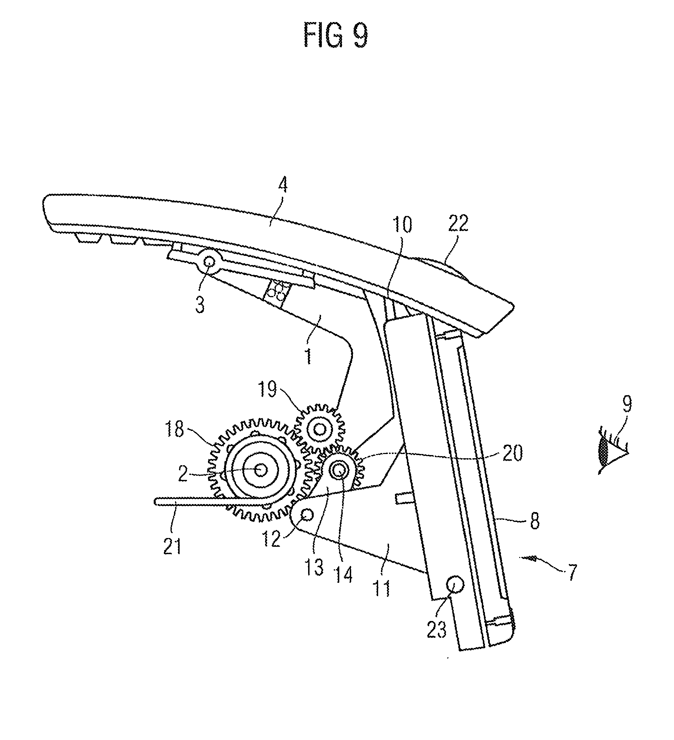

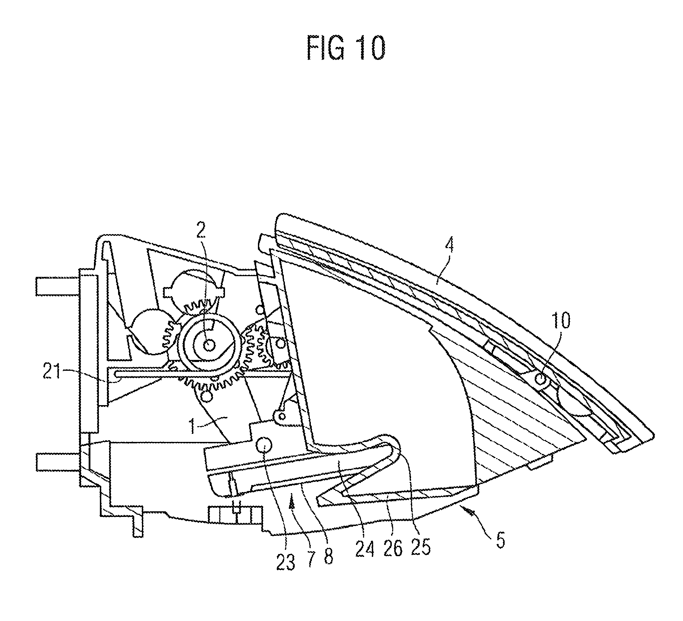

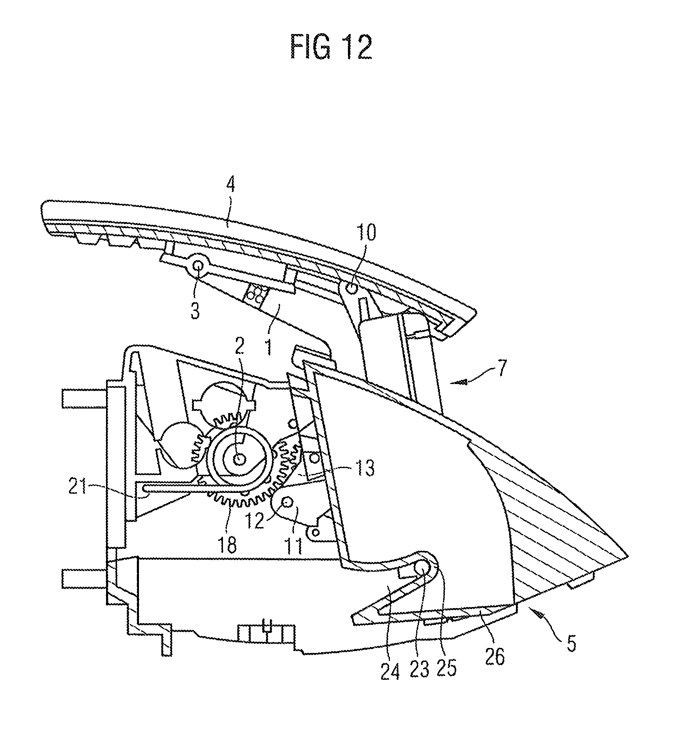

Über Kopplungsmittel ist die Abdeckung 4 zwischen einer Ruheposition, in der die Gehäuseöffnung 6 verschlossen ist (Figuren 1, 4, 7, 10) und einer Freigabeposition, in der die Gehäuseöffnung 6 geöffnet ist (Figuren 3, 6, 9, 12) bewegbar antreibbar.

Durch die Kopplungsmittel ist die Abdeckung 4 mit einer Anzeigeeinheit 7 gekoppelt, die dabei aus einer Ruheposition (Figuren 1, 4, 7, 10), in der sich die kastenartig ausgebildete und ein Display 8 aufweisende Anzeigeeinheit 7 annähernd horizontal vollständig in dem Gehäuse 5 befindet, in eine Anzeigeposition (Figuren 3, 6, 9,12) bewegbar ist.

Dabei erfolgt eine kombinierte rotatorische und translatorische Bewegung der Anzeigeeinheit 7, so dass diese aus der etwa waagrechten Ruheposition aus der Gehäuseöffnung 6 heraus in ihre annähernd senkrechte Anzeigeposition bewegt wird, in der das Display 8 zu einem Beobachter 9 gerichtet ist.

Die Koppelungsmittel weisen eine Koppel 1 auf, die mit ihrem einen Ende um eine ortsfeste erste Drehachse 2 schwenkbar gelagert ist.

An ihrem freien Ende ist die erste Koppel 1 mittels einer ersten Anlenkung 3 an der Abdeckung 4 angelenkt.

Die Anzeigeeinheit 7 ist an ihrem oberen Randbereich in einem Abstand zur ersten Anlenkung 3 der ersten Koppel 1 mittels einer zweiten Anlenkung 10 an der Abdeckung 4 angelenkt.

In ihrem unteren Bereich in einem Abstand zur zweiten Anlenkung 10 weist die Anzeigeeinheit 7 einen an ihrer dem Display 8 abgewandten Seite hervorstehenden Arm 11 auf, an dessen freiem Ende mittels einer dritten Anlenkung 12 eine zweite Koppel 13 mit ihrem einen Ende angelenkt ist, die mit ihrem anderen Ende um eine ortsfeste zweite Drehachse 14 schwenkbar gelagert ist.

An der ersten Drehachse 2 greift eine vorgespannte Torsionsfeder 21 an, durch die die erste Koppel 1 entgegen dem Uhrzeigersinn drehbar antreibbar ist.

In der Ruheposition der Anzeigeeinheit 7, in der sich die Abdeckung 4 in ihrer Abdeckposition befindet, ist die Abdeckung 4 durch eine nicht dargestellte Riegelvorrichtung arretiert.

Diese Riegelvorrichtung kann durch manuelle Betätigung eines an der Abdeckung 4 angeordneten Tasters 22 entarretiert werden, so dass dann durch die Vorspannkraft der Torsionsfeder 22 über die Kopplungsmittel die Abdeckung 4 aus der Abdeckposition in ihre die Gehäuseöffnung 6 freigebende Freigabeposition und die Anzeigeeinheit 7 aus ihrer Ruheposition in ihre Anzeigeposition bewegt wird.

Es versteht sich, dass der Federantrieb durch die Torsionsfeder 21 anstatt auf die erste Koppel 1 auch auf eine zweite

Koppel 13 einwirken kann, um zu derselben Öffnungs- und Ausfahrbewegung zu führen.

Zum Einfahren der Anzeigeeinheit 7 und Schließen der Gehäuseöffnung 6 durch die Abdeckung 4 wird die Abdeckung 4 manuell in ihre Abdeckposition gezogen, bis die Riegelvorrichtung wieder die Abdeckung arretiert und die Abdeckung 4 in ihrer Abdeckposition hält. Dabei wird gleichzeitig wieder die Torsionsfeder 21 gespannt.

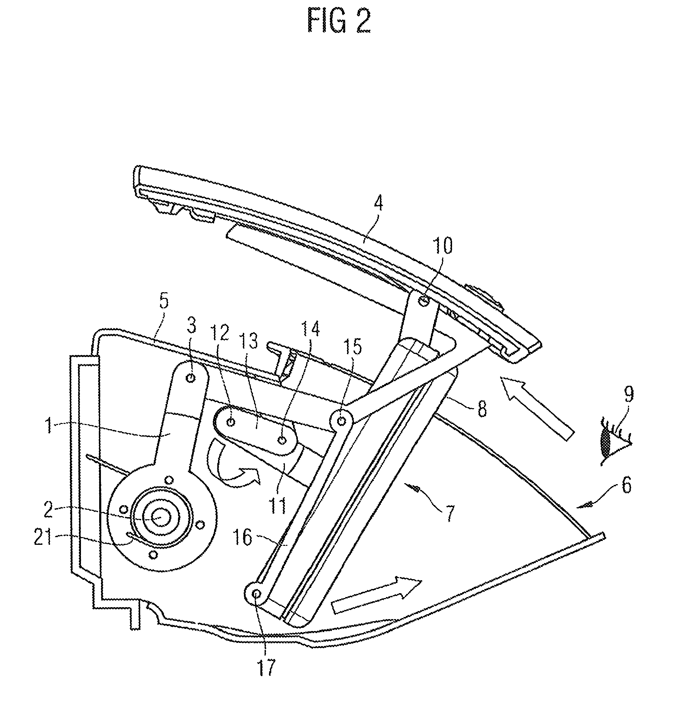

Bei dem Ausführungsbeispiel der Figuren 1 bis 3 ist mittels einer vierten Anlenkung 15 an der Abdeckung 4 eine dritte Koppel 16 mit ihrem einen Ende zwischen der ersten Anlenkung 3 und der zweiten Anlenkung 10 angelenkt. Das andere Ende der dritten Koppel 16 ist um eine ortsfeste dritte Drehachse 17 drehbar.

Dabei bilden die erste Koppel 1, die Abdeckung 4 und die dritte Koppel 16 ein Viergelenk.

Anstatt einem Antrieb der ersten Koppel 1 oder der zweiten Koppel 13 kann der Federantrieb durch die Torsionsfeder 21 auch auf die dritte Koppel 16 wirken, um zur Öffnungs- und Ausfahrbewegung zu führen.

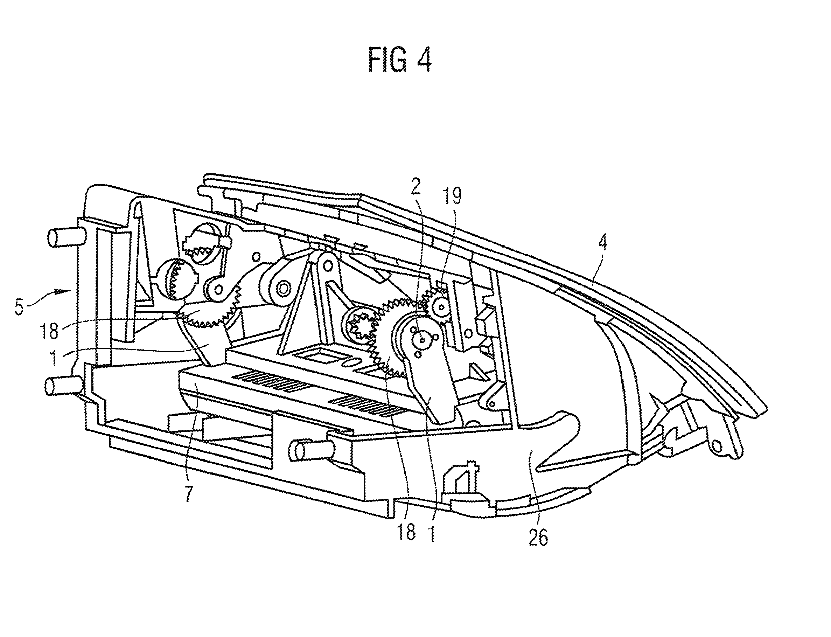

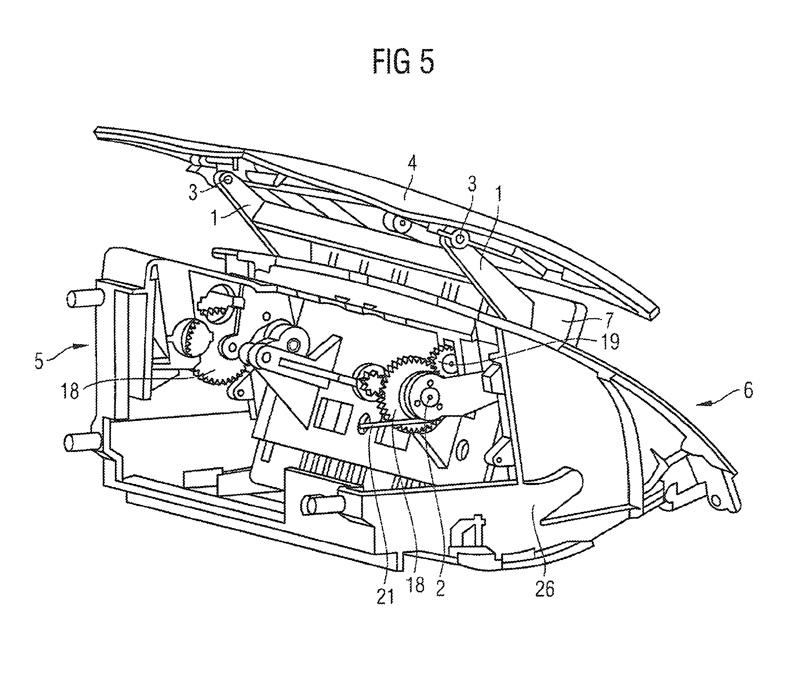

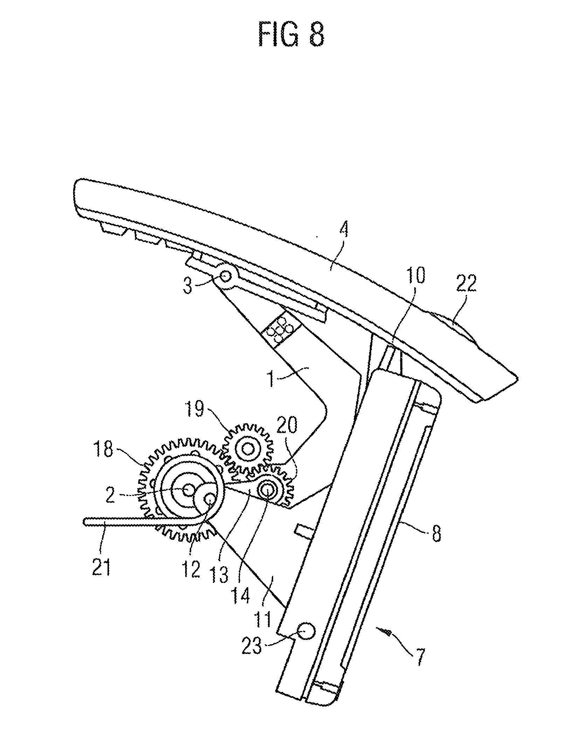

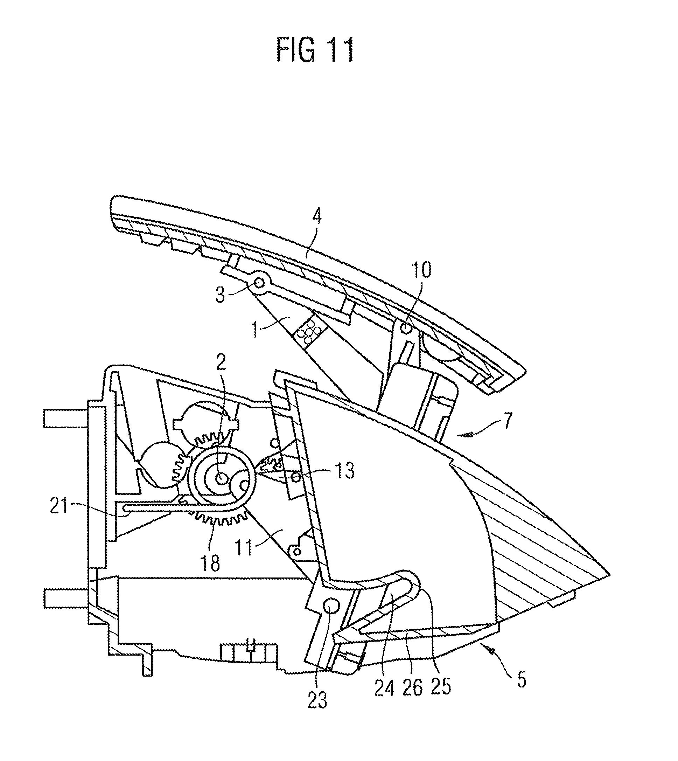

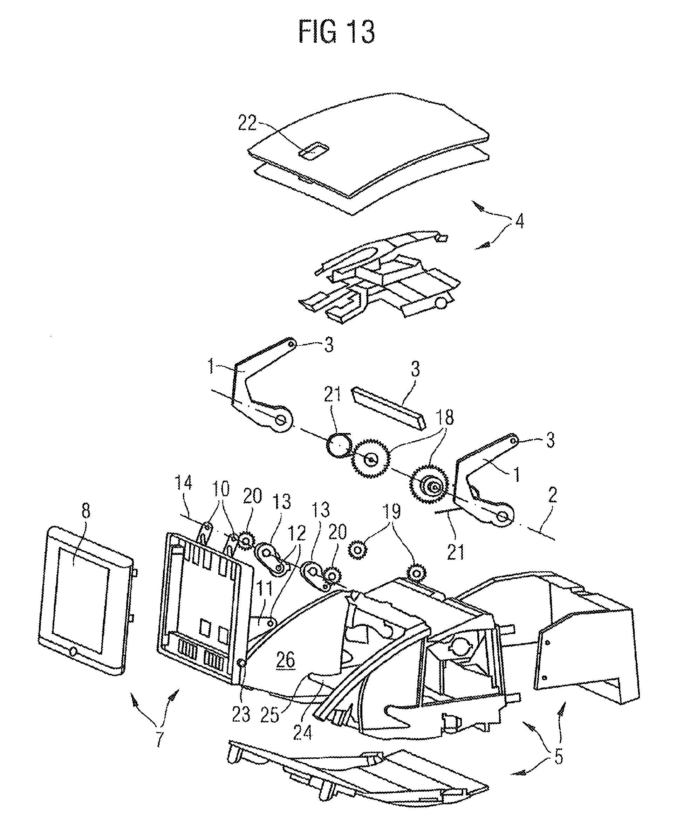

Bei dem Ausführungsbeispiel der Figuren 4 bis 13 ist auf der ersten Drehachse 2 drehfest ein Antriebsstirnzahnrad 18 angeordnet, das über ein frei drehbar gelagertes Zwischenstirnzahnrad 19 ein Abtriebsstirnzahnrad 20 antreibt, das drehfest auf der zweiten Drehachse 14 angeordnet ist.

In ihrem unteren Endbereich ragen beidseitig an der Anzeigeeinheit 7 Anschlagzapfen 23 quer zur Ausfahrbewegung hervor, die im letzten Teil der Ausfahrbewegung sich entlang deren Längserstreckung in Längsnuten 24 bewegen, bis sie an Anschläge 25 bildenden geschlossenen Enden der Längsnuten 24 zur Anlage kommen. Damit ist auch die Anzeigeposition der Anzeigeeinheit 7 erreicht. Die Längsnuten 24 sind in den Seitenwänden 26 des kastenartigen Gehäuses 5 ausgebildet.

## Patentansprüche

1. Anzeigeeinrichtung zur Anzeige von Informationen, insbesondere für ein Fahrzeug, mit einem eine Gehäuseöffnung aufweisenden Gehäuse und mit einer ein Display aufweisenden Anzeigeeinheit, die zwischen einer Ruheposition, in der die Anzeigeeinheit vollständig in das Gehäuse eingefahren ist, und einer Anzeigeposition, in der die Anzeigeeinheit aus dem Gehäuse in eine zumindest annähernd senkrechte Lage seines Displays ausgefahren ist, bewegbar antreibbar ist, mit einer Abdeckung, die zwischen einer die Gehäuseöffnung abdeckenden Abdeckposition und einer die Gehäuseöffnung freigebenden Freigabeposition bewegbar antreibbar ist, mit von einem Drehantrieb antreibbaren Kopplungsmitteln, mittels derer die Anzeigeeinheit und die Abdeckung bewegbar antreibbar sind und mit denen die Bewegungen der Anzeigeeinheit und der Abdeckung koppelbar sind, **dadurch gekennzeichnet , dass** die Kopplungsmittel eine um eine ortsfeste erste Drehachse (2) drehbare erste Koppel (1) aufweisen, deren freies Ende mittels einer ersten Anlenkung (3) an der Abdeckung (4) angelenkt ist, wobei die Anzeigeeinheit (7) in einem Abstand zur ersten Anlenkung (3) der ersten Koppel (1) mittels einer zweiten Anlenkung (10) an der Abdeckung (4) sowie in Abständen zur ersten Anlenkung (3) und zur zweiten Anlenkung (10) mittels einer dritten Anlenkung (12) an dem freien Ende einer zweiten Koppel (13) angelenkt ist, die mit ihrem anderen Ende um eine zur ersten Drehachse (2) ortsfeste zweite Drehachse (14) schwenkbar ist.

2. Anzeigeeinrichtung nach Anspruch 1, **dadurch gekennzeichnet, dass** mittels einer vierten Anlenkung (15) an der Abdeckung (4) zwischen der ersten Anlenkung (3) und der zweiten Anlenkung (10) eine dritte Koppel (16) mit ihrem einen Ende angelenkt ist, deren anderes Ende um eine ortsfeste dritte Drehachse (17) frei drehbar ist und mit der ersten Koppel (1), der Abdeckung (4) und der dritten Koppel (16) ein Viergelenk bildet.

3. Anzeigeeinrichtung nach einem der vorhergehenden Ansprüche, **dadurch gekennzeichnet , dass** eine der Koppeln (1, 13, 16) der Kopplungsmittel von dem Drehantrieb drehbar antreibbar ist.

4. Anzeigeeinrichtung nach Anspruch 1, **dadurch gekennzeichnet, dass** an der ersten Koppel (1) koaxial zur ersten Drehachse (2) ein erstes Getrieberad und an der zweiten Koppel (13) koaxial zur zweiten Drehachse (14) ein zweites Getrieberad drehfest angeordnet ist und die Drehbewegung des ersten Getrieberads über ein drehbar gelagertes Zwischenrad auf das zweite Getrieberad übertragbar ist.

5. Anzeigeeinrichtung nach Anspruch 4, **dadurch ge kennzeichnet,** dass die Getrieberäder und das Zwischenrad ein Stirnradgetriebe bilden.

6. Anzeigeeinrichtung nach einem der vorhergehenden Ansprüche, **dadurch gekennzeichnet , dass** die erste, zweite und dritte Koppel (1, 13, 16) oder die erste und zweite Koppel (1, 13) sowie die Getrieberäder und das Zwischenrad in dem Gehäuse (5) auf der der Gehäuseöffnung (6) abgewandten Seite der Anzeigeeinheit (7) angeordnet sind.

7. Anzeigeeinrichtung nach einem der vorhergehenden Ansprüche, **dadurch gekennzeichnet , dass** der Drehantrieb ein elektromotorischer Drehantrieb ist.

8. Anzeigeeinrichtung nach einem der vorhergehenden Ansprüche, **dadurch gekennzeichnet , dass** der Drehantrieb ein Federantrieb, insbesondere ein Torsionsfederantrieb ist, durch den die erste Drehachse (2) in Öffnungsantriebsrichtung der Abdeckung (4) federbeaufschlagt ist.

9. Anzeigeeinrichtung nach Anspruch 8, **dadurch gekennzeichnet, dass** eine der Komponenten der Kopplungsmittel mittels einer manuell entarretierbaren Riegelvorrichtung in der Ruheposition der Anzeigeeinheit (7) oder der Abdeckposition der Abdeckung (4) arretierbar ist.

10. Anzeigeeinrichtung nach Anspruch 9, **dadurch gekennzeichnet, dass** die Riegelvorrichtung mittels eines am Gehäuse oder an der Abdeckung (4) angeordneten Tasters (22) entriegelbar ist.

11. Anzeigeeinrichtung nach einem der vorhergehenden Ansprüche, **dadurch gekennzeichnet , dass** die Anzeigeposition der Anzeigeeinheit (7) durch einen Anschlag (25) definiert ist, an dem die Anzeigeeinheit (7) in der Anzeigeposition in Anlage ist und der die Ausfahrbewegung der Anzeigeeinheit (7) begrenzt.

12. Anzeigeeinrichtung nach Anspruch 11, **dadurch gekennzeichnet , dass** die Anzeigeeinheit (7) einen sich quer zur Ausfahrbewegung der Anzeigeeinheit (7) erstreckenden Anschlagzapfen (23) aufweist, der mit der Ausfahrbewegung der Anzeigeeinheit (7) in einer Längsnut (24) bewegbar ist, deren eines Ende den Anschlag (25) bildet, an dem in der Anzeigeposition der Anschlagzapfen (23) in Anlage gelangt.

## Claims

1. Display device for displaying information, in particular for a vehicle, having a housing which has a housing opening and having a display unit which has a display and which can be movably driven between a rest position, in which the display unit is fully retracted into the housing, and a displaying position, in which the display unit is deployed out of the housing into an at least approximately vertical position of its display, having a cover which can be movably driven between a covering position, in which it covers the housing opening, and an opened-up position in which it opens up the housing opening, having coupling means which can be driven by a rotary drive and by means of which the display unit and the cover can be movably driven and with which the movements of the display unit and of the cover can be coupled, **characterized in that** the coupling means have a first coupler (1) which is rotatable about a positionally fixed first rotary axle (2) and whose free end is articulatedly connected to the cover (4) by means of a first articulated joint (3), with the display unit (7) being articulatedly connected by means of a second articulated joint (10) to the cover (4) at a distance from the first articulated joint (3) of the first coupler (1), and being articulatedly connected by means of a third articulated joint (12) to the free end of a second coupler (13) at distances from the first articulated joint (3) and from the second articulated joint (10), which second coupler (13) is pivotable with its other end about a second rotary axle (14) which is positionally fixed in relation to the first rotary axle (2).

2. Display device according to Claim 1, **characterized in that** a third coupler (16) is articulatedly connected with one of its ends by means of a fourth articulated joint (15) to the cover (4) between the first articulated joint (3) and the second articulated joint (10), the other end of which third coupler (16) is freely rotatable about a positionally fixed third rotary axle (17) and forms a four bar linkage with the first coupler (1), the cover (4) and the third coupler (16).

3. Display device according to one of the preceding claims, **characterized in that** one of the couplers (1, 13, 16) of the coupling means can be driven in rotation by the rotary drive.

4. Display device according to Claim 1, **characterized in that** a first gearwheel is arranged on the first coupler (1), for conjoint rotation therewith, coaxially with respect to the first rotary axle (2) and a second gearwheel is arranged on the second coupler (13), for conjoint rotation therewith, coaxially with respect to the second rotary axle (14), and the rotational movement of the first gearwheel can be transmitted via a rotatably mounted intermediate wheel to the second gearwheel.

5. Display device according to Claim 4, **characterized in that** the gearwheels and the intermediate wheel form a spur gearing.

6. Display device according to one of the preceding claims, **characterized in that** the first, second and third couplers (1, 13, 16) or the first and second couplers (1, 13) and also the gearwheels and the intermediate wheel are arranged in the housing (5) on that side of the display unit (7) which faces away from the housing opening (6).

7. Display device according to one of the preceding claims, **characterized in that** the rotary drive is an electromotive rotary drive.

8. Display device according to one of the preceding claims, **characterized in that** the rotary drive is a spring drive, in particular a torsion spring drive, by means of which the first rotary axle (2) is spring-loaded in the opening drive direction of the cover (4).

9. Display device according to Claim 8, **characterized in that** one of the components of the coupling means can be locked in the rest position of the display unit (7) or in the covering position of the cover (4) by means of a manually unlockable locking device.

10. Display device according to Claim 9, **characterized in that** the locking device can be unlocked by means of a button (22) arranged on the housing or on the cover (4).

11. Display device according to one of the preceding claims, **characterized in that** the displaying position of the display unit (7) is defined by a stop (25) against which the display unit (7) abuts in the displaying position, and which delimits the deploying movement of the display unit (7).

12. Display device according to Claim 11, **characterized in that** the display unit (7) has a stop peg (23) which extends transversely with respect to the deploying movement of the display unit (7) and which, with the deploying movement of the display unit (7), can be moved in a longitudinal groove (24), one end of which forms the stop (25) against which the stop peg (23) abuts in the displaying position.

## Revendications

1. Dispositif d'affichage pour l'affichage d'informations, notamment pour un véhicule, comprenant un boîtier ayant une ouverture et une unité d'affichage ayant un écran, qui peut être entraîné en déplacement entre une position de repos, dans laquelle l'unité d'affichage est rentrée complètement dans le boîtier, et une position d'affichage, dans laquelle l'unité d'affichage est sortie du boîtier dans une position au moins à peu près verticale de son écran, comprenant un recouvrement, qui peut être entraîné en déplacement entre une position de recouvrement recouvrant l'ouverture du boîtier et une position de dégagement dégageant l'ouverture du boîtier, comprenant des moyens d'accouplement, qui peuvent entraînés par un entraînement en rotation et au moyen desquels l'unité d'affichage et le recouvrement peuvent être entraînés en mouvement, et par lesquels les mouvements de l'unité d'affichage et du recouvrement peuvent être accouplés, **caractérisé en ce que** les moyens d'accouplement ont une première bielle (1) pouvant tourner autour d'un premier axe (2) de rotation fixe en position, dont l'extrémité libre est articulée au recouvrement (4) au moyen d'une première articulation (3), l'unité (7) d'affichage étant articulée à distance de la première articulation (3) de la première bielle (1) au moyen d'une deuxième articulation (10) au recouvrement (4) ainsi qu'à distance de la première articulation (3) et de la deuxième articulation (10) au moyen d'une troisième articulation (12) à l'extrémité libre d'une deuxième bielle (13), qui par son autre extrémité peut pivoter autour d'un deuxième axe (14) de rotation fixe en position par rapport au premier axe (2) de rotation.

2. Dispositif d'affichage suivant la revendication 1, **caractérisé en ce qu'**au moyen d'une quatrième articulation (15), une troisième bielle (16) est articulée par l'une de ses extrémités au recouvrement (4) entre la première articulation (3) et la deuxième articulation (10), l'autre extrémité de l'accouplement (16) pouvant tourner librement autour d'un troisième axe (17) de rotation fixe en position et formant avec la première bielle (1), le recouvrement (4) et la troisième bielle (16) un quadrilatère articulé.

3. Dispositif d'affichage suivant l'une des revendications précédentes, **caractérisé en ce que** l'une des bielles (1, 13, 16) des moyens d'accouplement peut être entraînée en rotation par l'entraînement en rotation.

4. Dispositif d'affichage suivant la revendication 1, **caractérisé en ce que** sur la première bielle (1) est montée, solidaire en rotation coaxialement au premier axe (2) de rotation, une première roue d'engrenage et, sur la deuxième bielle (13) coaxialement au deuxième axe (14) de rotation, une deuxième roue d'engrenage et le mouvement de rotation de la première roue d'engrenage peut être transmis à la deuxième roue d'engrenage par une roue intermédiaire montée tournante.

5. Dispositif d'affichage suivant la revendication 4, **caractérisé en ce que** les roues d'engrenage et la roue intermédiaire forment un engrenage à roue droite.

6. Dispositif d'affichage suivant l'une des revendications précédentes, **caractérisé en ce que** la première, la deuxième et la troisième bielles (1, 13, 16) ou la première et la deuxième bielles (1, 13,) ainsi que les roues d'engrenage et la roue intermédiaire sont montées dans le boîtier (5) du côté du dispositif (7) d'affichage éloigné de l'ouverture (6) du boîtier.

7. Dispositif d'affichage suivant l'une des revendications précédentes, **caractérisé en ce que** l'entraînement en rotation est un entraînement en rotation par un moteur électrique.

8. Dispositif d'affichage suivant l'une des revendications précédentes, **caractérisé en ce que** l'entraînement en rotation est un entraînement à ressort, notamment un entraînement à ressort de torsion, par lequel le premier axe (2) de rotation est soumis à l'action d'un ressort dans la direction de l'ouverture d'entraînement du recouvrement (4).

9. Dispositif d'affichage suivant la revendication 8, **caractérisé en ce que** l'un des éléments des moyens d'accouplement peut être arrêté dans la position de repos du dispositif (7) d'affichage ou dans la position de recouvrement du recouvrement (4) au moyen d'un dispositif de verrouillage pouvant être déverrouillé manuellement.

10. Dispositif d'affichage suivant la revendication 9, **caractérisé en ce que** le dispositif de verrouillage peut être déverrouillé au moyen d'une touche (22) disposée sur le boîtier ou sur le recouvrement (4).

11. Dispositif d'affichage suivant l'une des revendications précédentes, **caractérisé en ce que** la position d'affichage de l'unité (7) d'affichage est définie par une butée (25), sur laquelle l'unité (7) d'affichage est en contact dans la position d'affichage et qui limite le mouvement de sortie de l'unité (7) d'affichage.

12. Dispositif d'affichage suivant la revendication 11, **caractérisé en ce que** l'unité (7) d'affichage a une tenon (23) de butée, qui s'étend transversalement au mouvement de sortie de l'unité (7) d'affichage et qui peut être déplacé par le mouvement de sortie de l'unité (7) d'affichage dans une rainure (24) longitudinale, dont l'une des extrémités forme la butée (25), sur laquelle dans la position d'affichage le tenon (23) de butée vient en contact.
